Europäisches Patentamt

European Patent Office

Office européen des brevets

(11) Publication number: **0 118 757**
**A2**

## (12) EUROPEAN PATENT APPLICATION

(21) Application number: **84101263.6**

(22) Date of filing: **08.02.84**

(51) Int. Cl.³: **H 01 L 41/18**
**H 01 L 37/02**

A request pursuant to Rule 88 EPC for correcting the description has been filed on 17.04.84.

(30) Priority: **10.02.83 JP 20776/83**
**12.09.83 JP 168669/83**

(43) Date of publication of application:
**19.09.84 Bulletin 84/38**

(84) Designated Contracting States:
**DE FR GB IT**

(71) Applicant: **Daikin Kogyo Co., Ltd.**
**Shinhankyu Building No 1-12-39, Umeda Kita-ku**
**Osaka-shi Osaka-fu(JP)**

(72) Inventor: **Sako, Junichi**
**D34-212, No. 2 Fujishirodai 1-chome**
**Suita-shi Osaka-fu(JP)**

(72) Inventor: **Yagi, Toshiharu**
**1-4-23, Souen Hanayashiki**
**Takarazuka-shi Hyogo-ken(JP)**

(72) Inventor: **Higashihata, Yoshihide**
**21-21, Hitotsuya 2-chome**
**Settsu-shi Osaka-fu(JP)**

(72) Inventor: **Fukuyama, Kouji**
**21-21, Hitotsuya 2-chome**
**Settsu-shi Osaka-fu(JP)**

(74) Representative: **von Kreisler, Alek, Dipl.-Chem. et al,**
**Deichmannhaus am Hauptbahnhof**
**D-5000 Köln 1(DE)**

(54) Polymeric ferro-electric material.

(57) A polymeric ferro-electric material comprising a VdF-TrFE copolymer film having improved specific permittivity and piezoelectric constant after poling, which copolymer has such a crystalline melting endothermic peak Tm on a crystalline melting chart measured with DSC that the peak measured in the first run is broader than the peak which is measured in the second run under the same conditions as the first run with the film cooled to a room temperature after the first run.

## POLYMERIC FERRO-ELECTRIC MATERIAL

### Field of the Invention

The present invention relates to a polymeric ferro-electric material. Particularly, it relates to a polymeric ferro-electric material comprising a vinylidene fluoride- trifluoroethylnene copolymer and having improved ferro-electric properties, particularly specific permittivity, piezoelectricity and pyroelectricity after poling.

### Background of the Invention

A ferro-electric material has a Curie's point and shows a hysterisis loop in a plotting curve of polarization against intensity of electric field. Accordingly, such the material has strong remanent polarization. When the material is ferro-electric, it has piezoelectric and pyroelctric properties.

Piezoelectric or pyroelectric properties are properties that crystals of a material are electrically polarized corresponding to stress or thermal atress applied to the material. With the piezoelectric property, mechanical energy can be transformed to electric energy, and vice versa. The larger piezoelectric constant means better transformation efficiency, and therefore a material having the larger piezoelectric constant is more preferred as the piezoelectric material.

Typical piezoelectric materials are ceramics and some polymers. Among the polymers, generally fluorine-containing polymers have better piezoelectric property.

- 2 -

In addition to the good piezoelectric property, the fluorine-containing polymers have several preferable properties such that they are formed in a thin film having a large surface area and they can be mass-produced. Recently, the fluorine-containing polymers are, therefore, used in the acaustic field as a component of a head phone or a loudspeaker for high pitched sound.

Among the fluorine-containing polymers, polyvinylidene fluoride (hereinafter referred to as "PVdF") has a comparatively larger piezoelectric constant and has been studied vigorously both in fundamental research and in application research. As is well known, PVdF has three crystal forms, namely alpha, beta and gamma forms. Among them, only the beta form PVdF has such a large piezoelectric constant as is practically used. However, a PVdF film manufactured by means of a film extruder, which is most convenient for mass-production of a polymeric film at a low cost, has the alpha crystal form and only a very poor piezoelectric property. In order to convert the alpha form PVdF to the beta form one, it is necessary to stretch the former by several times. Further, the film should be heat-set to prevent shrinkage. The thus stretched PVdF film has anisotropy and its piezoelectric constant $d_{31}$ is usually about 10 to 15 pC/N. It is also known to manufacture the beta crystal PVdF by casting a solution of PVdF in an appropriate solvent. This method entails a problem using complicate processing and only affords a PVdF film having a piezoelectric constant of 10 to 15 pC/N. The piezoelctric constant of the cast PVdF film may be increased to 30 to 40 pC/N by a certain unusual process such as zone stretching (Murakami et al, Polym. Pre. Prints, _29_, 524, 1980). However, this process is not efficinent and not suitable for commercial production.

Copolymer of vinylidene fluoride (hereinafter referred to as "VdF") and trifluoroethylene (hereinafter referred to as "TrFE") is recently noted as a new piezoelectric material. The molecular structure in the crystal of the copolymer takes always trans-trans conformation with or without stretching and the piezoelectric constant of the extruded film as such is 10 to 15 pC/N, which can be increased by about 1.5 times by stretching and heat-set.

Electronic devices are required to be smaller and thus a capacitor as an element of the electronic devices must be made smaller.

Capacity of the capacitor is calculated according to the following equation:

$$C = \varepsilon' \varepsilon_0 (S/d)$$

wherein $\varepsilon'$ is specific permittivity of a dielectric material, $\varepsilon_0$ is specific permittivity of vacuum (0.0885 pF/cm), S is a surface area of the capacitor and d is a thickness of the capacitor. As is clear from the above equation, $\varepsilon'$ and S must be made large and d must be made small in order to obtain the capacitor having smaller size and larger capacity.

Although the polymeric material is easily made in a form of the thin film having a large area as discussed above, its specific permittivity is as small as 2 to 5. In order to produce a small capacitor having high performance, a dielectric polymeric material having large specific permittivity is required. The copolymer of VdF and TrFE is known as a highly dielectric polymeric material (cf. Japanese Patent Publication (unexamined) No. 69000/1977). The specific permittivity of the VdF-TrFE copolymer is about 15 (at room temperature and 1 KHz), which is 1.5 to 2.0 times larger than that of PVdF which has been known as a good dielectric polymeric material.

As a result of the extensive study on the ferro-electric property, particularly piezoelectric and dielectric properties of VdF-TrFE copolymers, it has now been found that a VdF-TrFE copolymer of which a crystlline melting endothermic peak and melting sub-peak on a crystalline melting chart measured with a differential scanning calorimeter (hereinafter referred to as "DSC") satisfy a certain requirement has specific permittivity of at least 25 (at 24°C and 1 KHz) and piezoelectric constant of at least 40 pC/N after poling.

Summary of the Invention

According to the present invention, there is provided a polymeric ferro-electric material comprising a VdF-TrFE copolymer film which has such a crystalline melting endothermic peak Tm on a crystalline melting chart measured with DSC that the peak measured in the first run is broader than the peak which is measured in the second run under the same conditions as in the first run with the film cooled to a room temperature after the first run.

Some of the copolymers according to the invention have a melting sub-peak Tm' at a lower temperature side of the crystalline melting peak Tm on the crystalline melting chart but others do not. When the sub-peak is present on the chart, the sub-peak measured in the first run is narrower than that measured in the second run.

Preferably, the copolymer contains 45 to 70 % by mole of VdF.

Brief Description of the Drawings

Fig. 1 shows a set of heated rolls to calender the copolymer film;

Fig. 2 shows two typical crystalline melting. charts of the copolymers according to the invention measured by means of DSC;

Fig. 3 shows a procedure to calculate a half value of the endothermic peak in the crystalline melting chart;

Fig. 4 shows the changes of specific permittivities with temperature of the copolymers of Example 2 and Comparative Example 3;

Fig. 5 shows the crystalline melting charts of the copolymers of in Example 2; and

Fig. 6 is a graph showing $d_{31}$ plotted against the drawing. ratio.

Detailed Description of the Invention

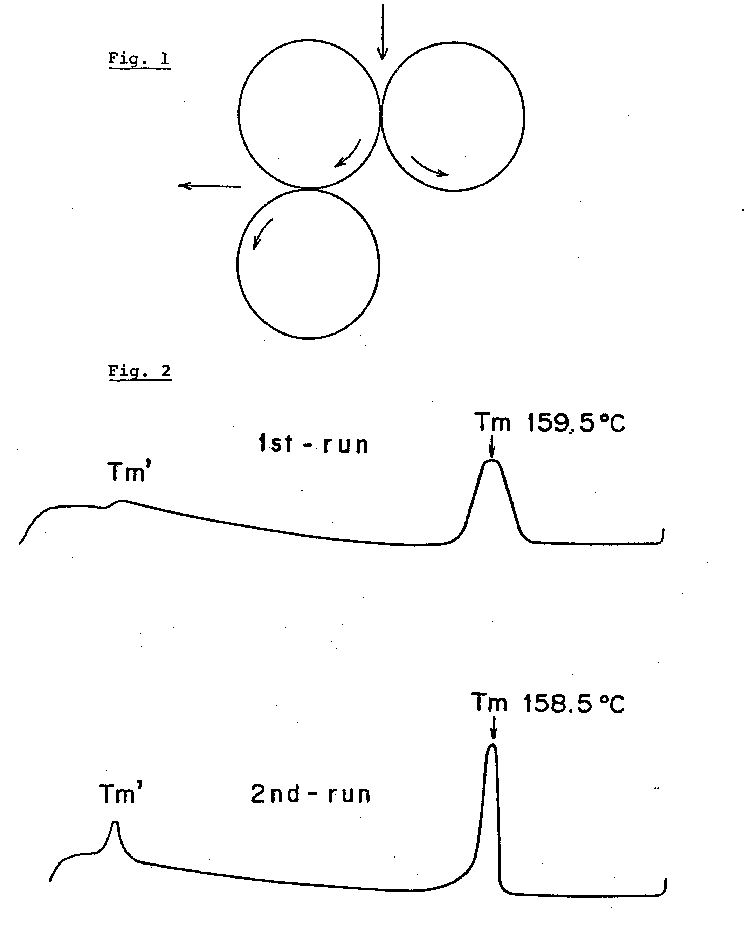

The polymeric ferro-electric material according to the invention may be prepared by calendering the copolymer film which has been formed by, for example, melt extrusion by means of a set of heated rolls kept at a temperature higher than a room temperature and lower than the melting point of the copolymer, preferably from 100 to 140°C and rotated at 0.1 to 10 rpm with the distance between the rolls of not more than about 100 micrometers as shown in Fig. 1. Usually, the thus calendered film is stretched at a draw ratio of 2 to 10.

Shapes of the crystalline melting endothermic peak Tm and the sub-peak Tm' if present measured in the first and second runs are greatly different as shown in Fig. 2. Such differences may be expressed quantitatively by half width of the melting endothermic peaks and of the sub-peaks recorded in the first and second runs.

The half width of the endothermic peaks is calculated from the DSC chart as follows:

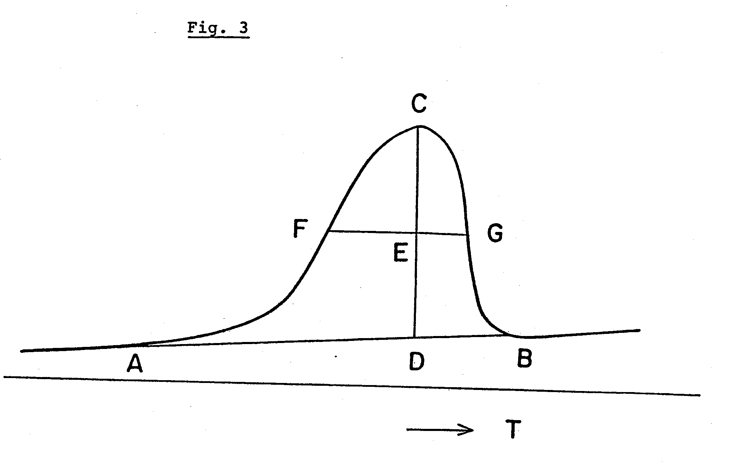

As shown in Fig. 3, firstly, a base line A-B is drawn and then a vertical line is drawn from the maximum point C to the temperature axis. D designates the intersection of the vertical line and the base line. From the middle point E between the points C and D, a line parallel to the temperature axis is drawn. The intersections of the parallel line and the DSC melting curve are F and G. The length of the segment F-G is the half width. Each half width quantitatively expresses the shape of the endothermic peak on the DSC chart measured under the same conditions and is compared with others. The ratio K of the half width of the melting endothermic peak Tm in the second run to the one measured in the first run is less than one since the latter is broader than the former. The copolymer having K value of less than one has specific permittivity of at least 20 (at 24°C and 1 KHz) and piezoelectric constant of 40 to 50 pC/N after poling.

The polymeric film according invention is subjected to poling treatment to impart piezoelectric property to the film. The poling is carried out by a per se conventional method. The poling conditions are as follows:

Temperature: 80 to 120°C, preferably about 100°C Electric field strength: 30 to 50 MV/m, preferably about 40 MV/m

Time: 20 to 40 minutes, preferably about 30 minutes Preferred Examples of the Invention

The present invention will be hereinafter explained further in detail by following Examples.

## Example 1 and Comparative Example 1

Films of the VdF-TrFE copolymers containing 52 % by mole, 54 % by mole, 65 % by mole and 73 % by mole (comparative) respectively were calendered by means of the rolls as shown in Fig. 1 kept at 120°C to give the sample films. Each film was subjected to the first measurement by DSC and cooled to a room temperature. Then, the film was subjected to the second measurement by DSC. The DSC used was Perkin-Elmer DSC-II. The measuring conditions were as follows:

Weight of the sample film:      7 mg

Sensitivity:                    10 mcal/min.

Rate of heating:                10°C/min.

Chart speed:                    10 mm/min.

The thus measured half width and the K-values are shown in Table 1.

Then, capacitor was made by vacuum metallizing aluminum on the both surfaces of each film to form electrodes, and its capacity was measured by means of 4247A Multi-Frequency LCR Meter (manufactured by Yokagawa-Hewlett-Packard). The results are also shown in Table 1.

Table 1

| | | VdF (mol %) | Half width | | K-value | ε' (1 KHz) 24°C |
|---|---|---|---|---|---|---|
| | | | 1st | 2nd | | |
| Example 1 | (1) | 52 | 9.0 | 4.0 | 0.44 | 18.6 |
| | (2) | 52 | 6.7 | 4.1 | 0.61 | 20.3 |
| | (3) | 54 | 8.5 | 4.0 | 0.47 | 21.5 |
| | (4) | 65 | 7.0 | 4.5 | 0.64 | 14.5 |
| | (5) | 65 | 8.3 | 4.9 | 0.59 | 16.7 |
| Comparative Example 1 | | 73 | 5.0 | 5.4 | 0.94 | 11.6 |

Comparative Example 2

Films casted from methyl ethyl ketone solutions of VdF-TrFE coplymers having the same compositions as those used in Example 1 (1), (2) and (4) and Comparative Example 1 were subjected to the DSC measurements and their specific permittivities were measured in the same manner as in Example 1. The results are shown in Table 2.

Table 2

| | | VdF (mol %) | Half width | | K-value | ε' (1 KHz) 24°C |
|---|---|---|---|---|---|---|
| | | | 1st | 2nd | | |
| Comparative Example 2 | (1) | 52 | 3.5 | 4.7 | 1.3 | 11.8 |
| | (2) | 52 | 4.0 | 5.2 | 1.3 | 11.5 |
| | (3) | 65 | 3.7 | 5.0 | 1.4 | 11.7 |
| | (4) | 73 | 3.7 | 4.7 | 1.3 | 10.9 |

Example 2 and Comparative Example 3

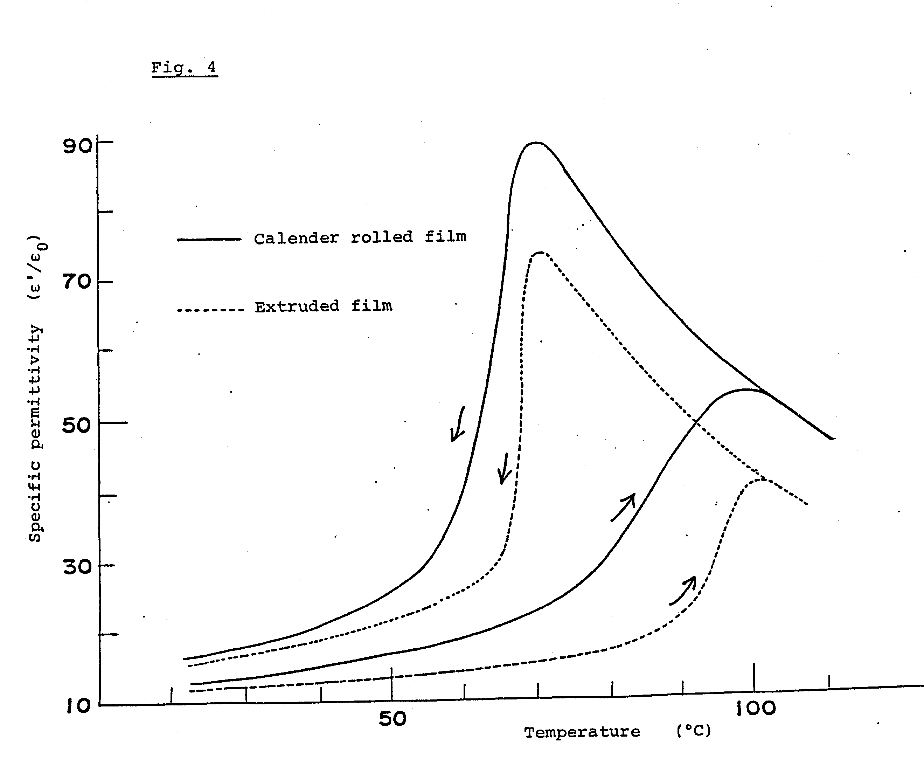

Specific permittivity of the calender rolled film of the same VdF-TrFE copolymer as prepared in Exmple 1 (4) was measured at several temperatures between a room temperature and 110°C. The results are shown in Fig. 4, in which the lower and upper lines show the change of the specific permittivity recorded when the temperature was raised and lowered respectively. The DSC chart was the same as in Example 1.

In Fig. 4, a melting sub-peak Tm', which is one of the characteristics of the VdF-TrFE copolymer, is present at 100°C and at 70°C on the lower and upper lines respectively. Particularly, the specific permittivty of the copolymer at the melting sub-peak (70°C) is 90, which is higher than any other specific permittivity appeared in the literatures.

As Comparative Example 3, specific permittivity of an extruded film of a copolymer having the same composition was measured at 1 KHz. The dotted line in Fig. 4 shows the results, from which it is understood that the specific permittivity of the extruded film is only 0.77 to 0.5 time of the copolymer according to the invention both in raising and lowering the temperature.

Example 3 and Comparative Example 4

Films of the VdF-TrFE copolymers containing 52 % by mole, 65 % by mole and 73 % by mole (comparative) respectively were calendered and subjected to the DSC measurements in the same manner as in Example 1.

The thus measured half width and the K-values are shown in Table 3.

The films were poled under the following conditions:

Temperature: 100°C

Electric field strength: 40 MV/m

Time: 30 minutes

The files were cooled to a room temperature and their piezoelectric constant $d_{31}$ were measured by means of Reovibron DDV-II-EA (manufactured by Toyo-Boldwin).

The piezoelectric constants are also shown in Table 3.

Table 3

| | | VdF (mol %) | Half width | | K-value | $d_{31}$ (pC/N) |
|---|---|---|---|---|---|---|
| | | | 1st | 2nd | | |
| Example 3 | (1) | 52 | 9.0 | 4.0 | 0.44 | 42 |
| | (2) | 52 | 6.7 | 4.1 | 0.61 | 40 |
| | (3) | 65 | 7.0 | 4.5 | 0.64 | 30 |
| Comparative Example 4 | | 73 | 5.0 | 5.4 | 0.94 | 14 |

Comparative Example 5

Films made by casting solutions in methyl ethyl ketone of VdF-TrFE copolymers having the same compositions as those used in Example 3 and Comparative Example 4 were subjected to the DSC measurements and their piezoelectric constants were measured in the same manner as in Example 3. The results are shown in Table 4.

Table 4

|  | | VdF (mol %) | Half width | | K-value | $d_{31}$ (pC/N) |
|---|---|---|---|---|---|---|
|  | | | 1st | 2nd | | |
| Comparative Example 5 | (1) | 52 | 3.5 | 4.7 | 1.3 | 20 |
| | (2) | 52 | 4.0 | 5.2 | 1.3 | 20 |
| | (3) | 65 | 3.7 | 5.0 | 1.4 | 15 |
| | (4) | 73 | 3.7 | 4.7 | 1.3 | 12 |

Example 4 and Comparative Example 6

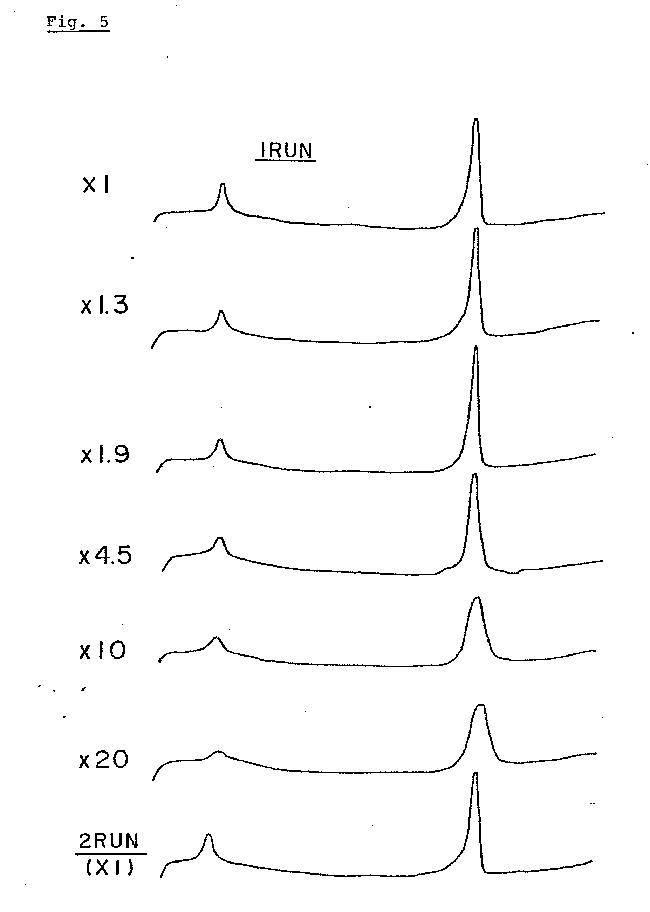

A film of VdF-TrFE copolymer containing 54 % by mole of VdF was calendered in the same manner as in Example 3 but at a draw ratio of 1.3, 1.9, 4.5, 10 or 20 by varying the distance between the heated rolls. The calendered films as well as the uncalendered film were subjected to the DSC measurement under the same conditions as in Example 3. The DSC charts of the calendered films in the first run and that of the uncalendered film in the second run are shown in Fig. 5. The half values and the K-values are shown in Table 5.

Table 5

|  | Draw ratio | Half width | | K-value |
| --- | --- | --- | --- | --- |
|  |  | 1st | 2nd |  |
| Example 4 | 4.5 | 4.5 | 3.8 | 0.84 |
|  | 10 | 7 | 3.6 | 0.51 |
|  | 20 | 7.8 | 4 | 0.51 |
| Comparative Example 6 | 1.0 | 3.8 | 4 | 1.05 |
|  | 1.3 | 3.8 | 4.2 | 1.11 |
|  | 1.9 | 3.2 | 4 | 1.25 |

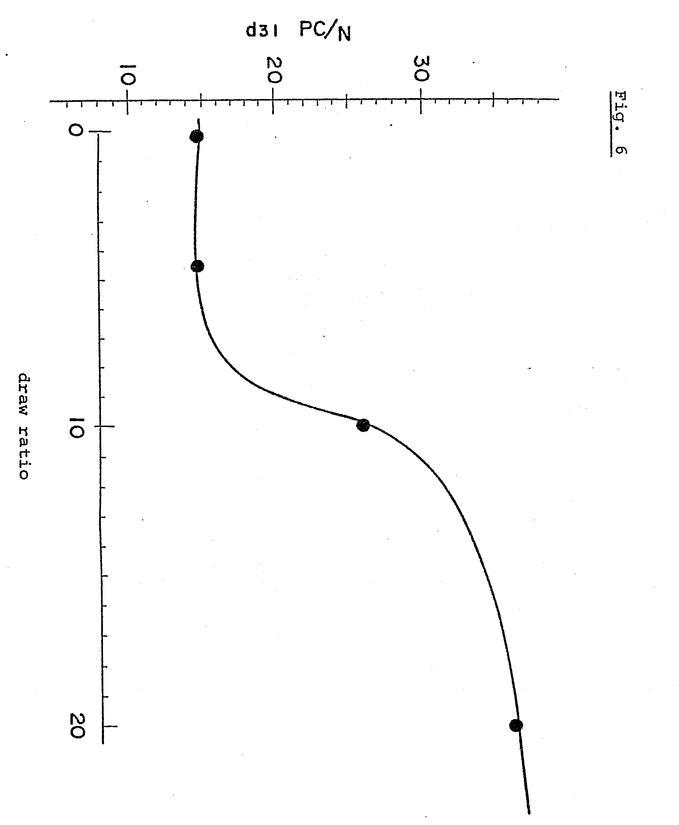

The piezoelectric constants $d_{31}$ are plotted against the draw ratios in Fig. 6. The constant increases from the draw ratio of about 10, which is expected from the results of the DSC measurement.

What is claimed is:

1. A polymeric ferro-electric material comprising a vinylidene fluoride-trifluoroethylene copolymer film which has such a crystalline melting endothermic peak on a crystalline melting chart measured with DSC that the peak measured in the first run is broader than the peak which is measured in the second run under the same conditions as in the first run with the film cooled to a room temperature after the first run.

2. A polymeric ferro-electric material according to claim 1, wherein the copolymer contains 45 to 70 % by mole of vinylidene fluoride.

3. A polymeric ferro-electric material according to claim 1, wherein the ratio K of the half width of the melting endothermic peak measured in the second run to the one measured in the first run is less than one.

4. A polymeric ferro-electric material according to claim 1, wherein the copolymer has permittivity of at least 20 (at 24°C and 1 KHz).

5. A polymeric ferro-electric material according to claim 1, wherein the copolymer has piezoelectric constant of 40 to 50 pC/N after poling.

6. A polymeric ferro-electric material comprising a vinylidene fluoride-trifluoroethylene copolymer film which has such a crystalline melting endothermic peak on a crystalline melting chart measured with DSC that the peak measured in the first run is broader than the peak which is measured in the second run under the same conditions as in the first run with the film cooled to a room temperature after the first run and further such a melting sub-peak at a lower temperature side of the crystalline melting peak on the crystalline melting chart that the sub-peak measured in the first run is narrower than that measured in the second run.

7. A polymeric ferro-electric material according to claim 6, wherein the copolymer contains 45 to 70 % by mole of vinylidene fluoride.

8. A polymeric ferro-electric material according to claim 6, wherein the ratio K of the half width of the melting endothermic peak measured in the second run to the one measured in the first run is less than one.

9. A polymeric ferro-electric material according to claim 6, wherein the copolymer has permittivity of at least 20 (at 24°C and 1 KHz).

10. A polymeric ferro-electric material according to claim 6, wherein the copolymer has piezoelectric constant of 40 to 50 pC/N after poling.

11. A process for preparing a polymeric ferro-electric material comprising a vinylidene fluoride-trifluoroethylene copolymer film which has such a crystalline melting endothermic peak on a crystalline melting chart measured with DSC that the peak measured in the first run is broader than the peak which is measured in the second run under the same conditions as the first run with the film cooled to a room temperature after the first run, which process comprises calendering the copolymer film at a temperature higher than a room temperature and lower than the melting point of the copolymer.

12. A process according to claim 11, wherein the calendering temperature is from 100 to 140°C.

13. A process for preparing a polymeric ferro-electric material comprising a vinylidene fluoride-trifluoroethylene copolymer film which has such a crystalline melting endothermic peak on a crystalline melting chart measured with DSC that the peak measured in the first run is broader than the peak which is measured in the second run under the same conditions as in the first run with the film cooled to a room temperature after the first run and further such a melting sub-peak at a lower temperature side of the crystalline melting peak on the crystalline melting chart that the sub-peak measured in the first run is narrower than that measured in the second run, which process comprises calendering the copolymer film at a temperature higher than a room temperature and lower than the melting point of the copolymer.

14. A process according to claim 13, wherein the calendering temperature is from 100 to 140°C.

Fig. 1

1/5

Fig. 2

1st - run

Tm' 

Tm 159.5 °C

2nd - run

Tm'

Tm 158.5 °C

Fig. 3

Fig. 4

Specific permittivity ($\varepsilon'/\varepsilon_0$)

——— Calender rolled film

------- Extruded film

Temperature (°C)

Fig. 5

5/5

Fig. 6